# EUROPEAN PATENT APPLICATION

(11) **EP 3 654 051 A1**
(43) Date of publication of application: **20.05.2020**
(21) Application number: 18206365.1
(22) Date of filing: 15.11.2018
(51) Int. Cl.: G01R 33/54, G06F 9/54

(54) **METHOD OF GENERATING A MAGNETIC RESONANCE PULSE SEQUENCE VIA RECURSIVE EVENT HANDLING**

(71) Applicant: Siemens Healthcare GmbH, 91052 Erlangen (DE)
(72) Inventor: Kluge, Thomas, 96114 Hirschaid (DE)

(57) **Abstract**

In one aspect the invention relates to a method generating control commands for execution on an MR scanner (MR1, MR2). The method comprises: Receiving (S1) an MR sequence via an input interface (101); Partitioning (S2) the MR sequence in a sequence of time slices (ts1, ts2,...tsn; Defining (S3) an extendable set of sequence block control data types (sb1, sb2,...sbn), wherein a sequence block control data type (sb1, sb2,...sbn) represents a formalized and a self-contained description of a time slice (ts) of the MR sequence; Mapping (S5) each time slice (ts) to at least one instance of a sequence block control data type (sb) or to at least one instance of a fundamental control data type (f) for providing (S6) a stream of events (e1, e2, ..ei); Providing (S7) an event handler (EH) for each event (e) wherein each of the event handlers (EH) is adapted for processing at least one event (e); Accessing (S8) a dispatcher (D) for reading each event (e) in the provided stream of events and passing each event (e) together with the dispatcher (D) itself to an appropriate event handler (EH), so that the dispatcher (D) may be called recursively by the event handlers (EH). Finally, fundamental control data types are translated into concrete control commands of the particular scanner to be used for execution on the MR scanner (MR1, MR2).

## Description

The invention relates to a method for generating control commands for MR scanner pulse sequences for acquiring imaging information using a magnetic resonance scanner, a corresponding system and a corresponding computer program.

Measurement sequences are necessary to control the MR scanner.

In particular, the generation of MR images in an MR scanner requires an exact, temporal correlation between the radiofrequency excitation of the spins, the spatial coding and the detection of the resonant response of the spins. The temporal correlation of the excitation, preparation and detection is called a pulse sequence or measurement sequence. A single segment of the measurement sequence can be classified according to its purpose. This division is designated as a time slice. A time slice is thus an established time segment within the measurement sequence that serves a specific purpose, for example the excitation of the nuclear spins. Time slices contain control instructions for the MR scanner. The time slices precisely determine what the MR scanner has to do and at which point in time. A series of time slices can be executed in the MR scanner because it contains all instructions and their temporal correlation to the control of the MR scanner. Alternatively, the execution of the time slices with a control unit connected with the MR scanner is also possible.

A measurement sequence can be executed as a series of time slices in the MR scanner. Within the measurement sequence for execution in an MR scanner, the time slices are joined seam-lessly (i.e. without gaps). Each of the time slices has a specific length, and at least one pulse with a pulse shape is associated with every time slice. Each of the time slices can be associated with a type from the set: transmission type for transmission of RF power; reception type to detect the resonant response of the nuclear spins; and warp type to prepare the nuclear spins. Time slices of the transmission type are used as excitation pulses to excite the nuclear spins, to refocus the nuclear spins, and in a hybrid form that serves both for excitation and for refocusing. In addition to these, there are time slices in which RF energy is emitted and/or an RF signal is received. Moreover, RF pulses are known for the inversion of the nuclear magnetization, called inversion pulses.

The generation of different MR sequences or measurement sequences is necessary in order to generate MR images with the appropriate diagnostic information. For example, it is possible to significantly affect the contrast of an image by the selection of a proper measurement sequence. The preparation of the spin system, for example by means of pulses for RF excitation, gradient pulses, wait times, has a decisive influence on the quality and property of the acquired MR image.

Usually, measurement sequences for execution in an MR scanner may be prepared by a sequence programmer, e.g. in one of the known programming languages, like C++, describing all properties and the temporal sequence of the time slices in a completely parameterized form and with permissible parameter values for execution in the MR scanner.

A measurement sequence for execution in an MR scanner in a clinical everyday situation typically is composed of 1000 to 1000000 time slices, that are involved in a sensitive temporal correlation among one another.

Thus, a pulse sequence in the context of magnetic resonance scanners can be defined as the sequence of control instructions for the acquisition of imaging information in the magnetic resonance (MR) scanner. The pulse sequence can for example comprise one or more radio frequency (RF) pulses to be radiated into the tissue of a subject, together with instructions controlling a magnetic field surrounding the subject, such as a direction, strength and structure (e.g. gradient) thereof. Parameters of the pulse sequence are known in the art and include, for instance, duration or measurement time, total energy, power, and a parameter defined within the scope of the temporal subrange, such as an amplitude, a duration and a shape of gradient and RF pulses, or coil settings for acquisition procedures. An overview of computer-aided MR imaging (MRI) pulse sequence generation is given in e.g. "Handbook of MRI Pulse Sequences" by M. Bernstein et al, Elsevier, 2004, with basic pulse functions in Chapter 3, p. 67 to 84 for instance.

It is known to create pulse sequences from multiple sequence building blocks, which are high in number and complexity, such that a manual combination and contextual redevelopment of methods requires a large amount of resources in development, methodological expertise and quality assurance. Generating MR sequences by combining sequence blocks is challenging due to the dependency depth of parameters associated with the respective sequence blocks since methods and parameter dependencies, i.e. dependencies necessary for calculating the respective sequence block, are hard to abstract. More precisely, the operator must know exactly which parameters the respective sequence block depends on to have that respective parameter readily available at the time of calculating the sequence block.

Generally, there are a plurality of different scanner types, including scanners with different functionalities, with different hardware and/or software, with different technical resources (e.g. coils, magnetic field strength, gradient strength and switching speed, number of receive/transmit coils, hardware duty cycles, reconstruction speed and memory capacity ...). All these kind of different scanner types need to be considered when generating MR sequences.

For developing MRI sequences, it is known in state of the art to use computer programs, which assist in defining MRI sequences.

However, the existing programs are complex and cumbersome. Known programming paradigms are based on a monolithic concept and are not or only partly adapted to the specific use case. There is a need to provide a program which is simpler to be used and may be extended easily. Further, existing programs are architecture specific and must be recompiled whenever the sequence is ported to a new scanner type or just to a new software version of the same scanner. Unfortunately, there is no abstraction level separating the control of the scanner hardware from the physical definition of the events of the pulse sequence.

It is therefore an object of the present invention to provide a solution for making MRI sequence generation easier, more efficient and more flexible, so that generated sequences may be ported easily to other scanner types. Further, performance should be increased for the resource intensive complex task.

This object is solved by a method for generating control commands for execution on a plurality of different MR scanner types, by a system, by a computer program according to the appended independent claims. Advantageous aspects, features and embodiments are described in the dependent claims and in the following description together with advantages.

In the following, the invention is described with respect to the claimed system as well as with respect to the claimed method. Features, advantages or alternative embodiments herein can be assigned to the other claimed objects (e.g. the computer program or a computer program product) and vice versa. In other words, the subject matter which is claimed or described with respect to the system can be improved with features described or claimed in the context of the method and vice versa. In this case, the functional features of the method are embodied by structural units of the system and vice versa, respectively.

In one aspect the invention relates to a method for generating control commands for execution on an MR scanner. The MR scanner may be of any different type. The method comprises:
- Receiving a provided stream of events representing the received MR sequence to be executed;
- Providing an event handler for each event type, wherein each of the event handlers is adapted for processing at least one event type;
- Accessing a dispatcher for reading each event in the provided stream of events and passing each event together with the dispatcher itself to an appropriate event handler, so that the dispatcher may be called recursively by the event handlers for generating control commands to be used for execution on the MR scanner.

The solution provides technical advantages. The suggested solution provides an extendable data-driven interface. Thus, it is not necessary to provide complex software interfaces, which is typically more complex and more difficult to understand.

With this system, method and program a maximal flexibility may be achieved with respect to a level of abstraction of the control data.

The system and method and program provide a high degree of modularity and decouples control of scanner hardware from the physical definition of the events, representing the MR sequence.

Further, the system, method and program provide a maximum degree of scalability due to the option to define new events and event handlers.

According to a preferred embodiment the method may further comprise the following steps, which are directed for the provisioning or the stream of events:
- Receiving an MR sequence via an input interface;
- Partitioning the MR sequence in a sequence of time slices, each time slice being a continuous uninterrupted period of time within the MR sequence;
- Defining an extendable set of sequence block control data types, wherein a sequence block control data type represents a formalized (generic and standardized) and a self-contained description of a time slice of the MR sequence;
- Mapping each time slice to an instance of a sequence block control data type or an instance of a fundamental control data type for providing the stream of events.

According to another preferred embodiment, the event in the stream of events is a package consisting of a uniform unique identifier (UUID), a data size in bytes and the event data itself, wherein the UUID and the data size is accessible separately from the event data. A UUID is to be construed as means for identifying datasets or information in computer systems. It may be a 128-bit number. UUIDs are documented as part of ISO/IEC 11578:1996 "Information technology - Open Systems Interconnection - Remote Procedure Call (RPC)" and more recently in ITU-T Rec. X.667 | ISO/IEC 9834-8:2005. With this feature each of the events is addressable in a dedicated manner. It is possible to unambiguously differentiate one first event from any other second event that potentially could be sent to the MR sequence. Preferably, the assignment between event and an appropriate event handler is realized by including the respective UUID in the event and within the dispatcher assigning this UUID to an event handler. Moreover, it is preferred that each of a fundamental control data types and of the sequence block control data types is identified in a uniform and unique manner and in particular by such a UUID.

According to another preferred embodiment, the recursive calls to the dispatcher can be used for applying a composite design pattern or a tree structure for generating single time slices or the complete MR sequence. This improves efficiency of the solution with respect to re-use of existing time slice types (resp. event) types and to event stream data rate.

It is one of the major advantages that the generated control commands are scanner-independent. Thus, the generated control commands may be used for execution on a variety of different scanners and platforms. The generated control commands may be translated into scanner-specific control commands by the respective appropriate event handler for execution on a particular scanner.

According to another preferred embodiment, the dispatcher and the event handler are both implementing the same interface for sequence block execution. With this feature, recursive calls of the dispatcher are possible which leads to a high degree of flexibility and efficiency.

According to another preferred embodiment, the definition of the set of sequence block control data types or the providing of the events is based on a provided abstract model for MR sequences. The abstract model may be stored in a data storage which is accessible via a network connection. For example, it is possible to use a model, which is described in DE 10 2008 044 823 B3, the contents of which are herein entirely incorporated by reference. The model may be based on an extendable set of fundamental control data types.

To provide a maximum degree of flexibility, preferably, the set of fundamental control data types and/or the set of sequence block control data types may be extended. Thus, the set of sequence block control data types may be extended easily by adding new control data types and the set of fundamental control data types may be extended by adding new fundamental control data types. Both is possible, without affecting existing code.

Moreover, the highest level of scalability is provided by making the set of event handlers extendable. In particular, the set of event handlers may be extended or adapted easily by adding new event handlers without affecting existing code.

In a preferred embodiment of the invention, the stream of events may be provided in a standardized format. The standardized format may be selected in a configuration phase. Possible options for such a standardized format are Json, HDF (hierarchical data format) or XML or - most efficiently - is a byte stream (that can be generated from any of the mentioned formats) as a stream of:
- 128bit UUID
- 64bit data size (=NB)
- NB bytes.

In another preferred embodiment of the invention, the steps of:
- mapping, which corresponds to a serialization of the MR sequence;
- accessing the dispatcher and
- calling the event handlers recursively
are implemented by a so called IRecursiveEventHandler interface, being a pure virtual or abstract base class in C++.

With this standardized format in mind, the interface for the recursive event handler, the IRecursiveEventHandler, in C++ could look like:

```
    class IRecursiveEventHandler
    {
    public:
        virtual void executeSequenceBlock(
            IRecursiveEventHandler &rRecursiveEventHandler,
            const UUID_t &rUUID,
            ConstMemPtr_t pMem,
            MemSize_t MemSize,
            ConstMemPtr_t pData,
            MemSize_t DataSize
             ) = 0;
        virtual ∼IRecursiveEventHandler () = default;
    };
```

In another preferred embodiment of the invention, the stream of events may be provided by a software Plug-In into the MR scanner control software. The Plug-In is just written for this specific purpose. The Plug-In interface is just designed for this purpose. It is to be noted, that the event handlers are also plug-ins via IRecursiveEventHandler interface. This together with the generic event stream data format leads to the high scalability.

In another aspect the invention relates to a computing unit for generating control commands for execution on an MR scanner. The computing unit comprises:
- An input interface for receiving a provided stream of events;
- An event handler which is provided for each event wherein each of the event handlers is adapted for processing one or more specific events;
- A dispatcher for reading each event in the provided stream of events and passing each event together with the dispatcher itself to an appropriate event handler, so that the dispatcher may be called recursively by the event handlers for generating control commands to be used for execution on the MR scanner.

The computing unit may comprise or interact with a second computing unit. The second computing unit may comprise modules which are responsible for providing the stream of events. The modules may comprise:
- An input interface for receiving an MR sequence;
- A partitioning unit, which is adapted for partitioning the received MR sequence in a sequence of time slices, each time slice being a continuous uninterrupted period of time within the MR sequence;
- A first storage for providing an extendable set of sequence block control data types, wherein a sequence block control data type represents a formalized and self-contained description of a time slice of an MR sequence;
- A mapping unit which is adapted for mapping each time slice to an instance of a sequence block control data type or to an instance of a fundamental control data type for providing a stream of events representing the received MR sequence.

In another aspect the invention relates to a system for generating control commands for execution on an MR scanner. The system comprises:
- At least one MR scanner to be operated with control commands to be generated. The scanner may be of any type (without any requirements with respect to hardware, software and even scanners from different manufacturers may be addressed.
- An input interface for receiving an MR sequence;
- A partitioning unit, which is adapted for partitioning the received MR sequence in a sequence of time slices, each time slice being a continuous uninterrupted period of time within the MR sequence;
- A first storage for providing an extendable set of sequence block control data types, wherein a sequence block control data type represents a formalized and self-contained description of a time slice of an MR sequence;
- A mapping unit which is adapted for mapping each time slice to an instance of a sequence block control data type or to an instance of a fundamental control data type for providing a stream of events representing the received MR sequence;
- An event handler for each event wherein each of the event handlers is adapted for processing one specific event type;
- A dispatcher for reading each event in the provided stream of events and passing each event together with the dispatcher itself to an appropriate event handler, so that the dispatcher may be called recursively by the event handlers for generating control commands to be used for execution on the MR scanner.

In another aspect the invention relates to a computer program for generating an MR sequence or parts thereof, the computer program comprising program code means for causing a computing entity to carry out the method as described above, when the computer program is run on the computing entity.

In the following a definition of terms, used within this document is given.

A sequence block control data type describes an electronic digital dataset, representing a formalized, abstract, generic and a self-contained description of a time slice of the MR sequence. The sequence block control data types are independent of the hardware, software and physical scanner properties. In a possible preferred embodiment, the types may be proprietary. Possible examples of a type are: slice selective excitation, readout with constant gradient, warp block, FLASH Kernel, TSE Kernel, inversion recovery, regional saturation, spectral selective saturation.

A fundamental control data type describes an electronic digital dataset. Fundamental control data types in contrast to sequence block control data types are on a sub-time-slice-level, i.e. they are used for building a complete time slice. They represent the MR scanner's physical capabilities, preferably on an abstract level. A fundamental control data type may be construed as low level command. Examples of a fundamental control data type are: Initialize a time slice, finalize a time slice, define duration of the time slice, insert an RF pulse (B1-field) into the time slice, insert a gradient pulse (Bz-field) into the time slice, insert a read-out interval into the time slice).

An event is an electronic dataset, representing a part of the MR sequence in a modeled manner. An event is either an instance of a sequence block control data type or an instance of a fundamental control data type.

An event handler is implemented as software for processing a particular event. An event handler may be implemented as a class implementing the IRecursiveEventHandler. One type of event handlers may be configured to process sequence block control data types and another type of event handlers may be configured to process fundamental control data types. Only the event handlers for fundamental control data types are communicating directly with the scanner interface or output interface. In a preferred embodiment, only the fundamental control data types have to be translated into scanner specific control commands.

A dispatcher may be implemented in software, e.g. C++. The functionality of the dispatcher is to control the processing workflow. It processes event after event within the stream of events. For processing a particular event, it passes the same together with the dispatcher itself to an associated event handler.

The control commands may be used to generate a MR sequence on a particular MR scanner. A control command may be construed as an event.

The input interface for receiving an MR sequence may be an application programming interface (API).

The input for the dispatcher, i.e. the stream of events, is provided by an exchangeable software plug-in with a specific interface.

In another aspect the invention relates to a computer program product comprising a computer program, the computer program being loadable into a memory unit of a computing unit, including program code sections to make the computing unit execute the method as described above, when the computer program is executed in said computing unit.

In another aspect the invention relates to a computer-readable medium, on which program code sections of a computer program are stored or saved, said program code sections being loadable into and/or executable in a computing unit to make the computing unit execute the method as described above, when the program code sections are executed in the computing unit.

The realization of the invention by a computer program product and/or a computer-readable medium has the advantage that already existing computing units, like servers or clients or even the MR scanners itself, can be easily adopted by software updates to work as proposed by the invention.

The properties, features and advantages of this invention described above, as well as the manner they are achieved, become clearer and more understandable in the light of the following description and embodiments, which will be described in more detail in the context of the drawings. This following description does not limit the invention on the contained embodiments. Same components or parts can be labeled with the same reference signs in different figures.

It shall be understood that a preferred embodiment of the present invention can also be any combination of the dependent claims or above embodiments with the respective independent claim.

These and other aspects of the invention will be apparent from and elucidated with reference to the embodiments described hereinafter.

In the drawings:
- Fig. 1: schematically and exemplarily shows a magnetic resonance (MR) scanner, which is operated by an associated computing entity;
- Fig. 2: is a flow chart of a method for generating control commands to be used for different MR scanner types according to a preferred embodiment of the invention;

The method according to the invention implements a sequence run functionality. In particular, it provides a translation or transformation of a hardware- and scanner-independent event streams into hardware- and scanner specific control commands to be executable on a MR scanner. The method may also be used for providing a (back) translation of scanner specific control commands into an abstracted form, into a scanner-independent event stream. The scanner specific control commands may be construed as measurement order.

An event is modeled in a standardized generic manner. It is marked with a unique identifier, e.g. an UUID (UUID, see https://de.wikipedia.org/wiki/Universally_Unique_Identifier), to unambiguously differentiate the event from any other event that potentially can be sent to the sequence. The event then provides a complete self-contained description of a continuous uninterrupted period of time. So, the sequence (a continuous series of continuous uninterrupted periods of time) in the time domain can be directly mapped to a stream of events. An advantageous and compact format for the events (when it comes to serialization of the event stream, the execution of the event stream in a real-time program, the expandability with new event types and the invariance in different programming languages) is a simple standardized binary format that e.g. consists of a UUID, a data size in bytes and the event data itself. Within the data section one is completely free to transport any content.

The first implementation of IRecursiveEventHandler is the sequence execution function itself (i.e. the sequence execution function is an IRecursiveEventHandler) which is the root event handler dispatching events to other implementations. It can be programmed in a way that allows to simply add an arbitrary number of other implementations of IRecursiveEventHandler to the sequence execution and map each of those implementations to one or more event UUIDs. Note that the mapping of a UUID to a handler should be unique to be able to unambiguously route a particular event to a distinct handler.

By passing the event handler itself recursively to the event handling function each implementation of IRecursiveEventHandler can make use of the root event dispatcher.

Any known functionality can be implemented as an IRecursiveEventHandler, for example:
- Execute a complete existing sequence. The event type would be the existing MR protocol structure.
- Execute events read from a file. The event type would be the file path.
- Execute events read from a remote computer via network. The event type would be the connection details for the remote computer.
- Execute a user defined loops structure and produce events that control other IRecursiveEventHandler implementations. This way the existing source code can be structured much more than it is today.
- A time slice sending an RF pulse over a constant gradient.
- A time slice sending an RF pulse over a non-constant gradient, e.g. for realizing a VERSE pulse.
- A time slice receiving data over a constant gradient.
- A time slice receiving data over a not constant gradient, e.g. ramp sampling on trapezoidal or sinusoidal ramps.
- A time slice switching 0^{th} order (or higher order) gradient moments between two gradient vectors.
- A time slice receiving data on a spiral or any other non-Cartesian 2d or 3d readout.
- A time slice sending a 2d or 3d excitation pulse over a complex gradient waveform.
- A command for loading a new library containing one or more IRecursiveEventHandler implementations at run time. The event type would be a library name.
- A command for mapping a UUID to a new or existing IRecursiveEventHandler implementation.

Generally, there are different groups of IRecursiveEventHandler implementations. In a first group, the method may be run on a particular MR scanner (or on a computing unit of the MR scanner). Alternatively, it may be run on any computing entity, associated to the MR scanner on behalf of the scanner, so that the scanner will be provided with the result data to execute the sequence. In the first group, the IRecursiveEventHandler is implemented specifically for the MR scanner system architecture it is supposed to run on. In a second group, the method may be decoupled from a particular MR scanner. It may be run on any computing entity. In this second group, the method may in particular be run on an on-premise computer for several scanners in a hospital or may even be run in the cloud for several hospitals. In the second group, the IRecursiveEventHandler will just take their input event and create new events and pass them recursively to IRecursiveEventHandler. Those implementations will be completely independent of the underlying system architecture and are not hardware- and scanner-specific and can be regarded as stable software components.

It is to be noted that the standardized serialization format may be, but does not necessarily have to be binary, it can also be some other standardized format like JSon or XML. The key requirement is that the unique identifier must be visible separately from the content. The transport layer must be able to transport the data. It is solely the receiver, i.e. a specific IRecursiveEventHandler implementation, which must be able to de-serialize the content.

Further, it should be noted that an event handler only shows direct dependency to the specific control data types it processes and to the control data types it passes to the recursive event handler and not to other data, e.g. data deeper in a calling tree structure.

In the following the invention will be further described with respect to the figures.

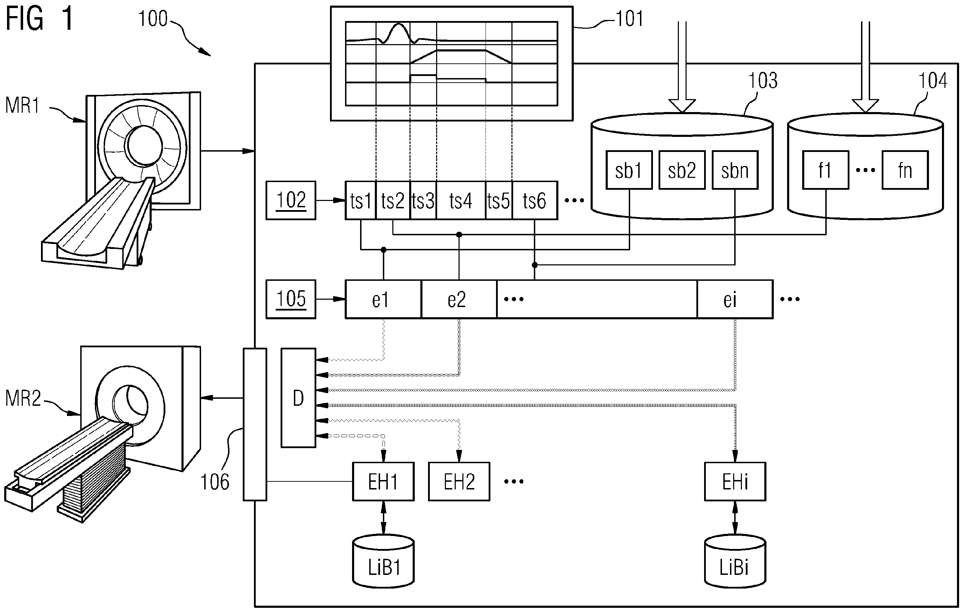

Fig. 1 schematically and exemplarily shows a system 100 in an overview manner. A first magnetic resonance (MR) scanner MR1 and a second MR scanner are provided. The first scanner MR1 and the second scanner MR2 may be of different type, e.g. different software, hardware and/or different physical capabilities. The scanners MR are controlled by a computing unit, which is represented in Fig. 1 with the biggest rectangle on the right side, which is together with the associated MR scanners MRi a major part of the system 100 and has respective digital interfaces to the scanners and to other data entries, e.g. for receiving a sequence or a stream of events.

In particular, the computing unit, described above, comprises an input interface 101, which is adapted for receiving a MR sequence. Additionally, optional further interfaces may be provided, e.g. for receiving and storing a set of sequence block control data types sb in a storage 103 and/or for receiving and storing a set of fundamental control data types, which are used to build fundamental control data types f in another storage 104.

A partitioning unit 102 is provided for partitioning the received MR sequence into time slices ts (in Fig. 1 ts1, ts2, ...ts6...).

A mapping unit 105 is provided which is adapted for mapping each time slice ts to an instance of a sequence block control data type sb or to an instance of a fundamental control data type, which is of fundamental control data type f for providing a stream of events e representing the received MR sequence. With other words, the received MR sequence via interface 101 and the times slices, provided by the partitioning unit 102 serves a source or input for the stream of events, which is provided by the mapping unit 105.

An event handler EH is provided for each event e, wherein each of the event handlers EH1, EH2, ...EHi is adapted for processing one or more specific events e1, e2, ...ei. An event handler EH may preferably be provided with a storage and an interface for receiving and storing of new event handlers.

A dispatcher D is provided and adapted for reading each event e in the provided stream of events and passing each event e together with the dispatcher D itself to an appropriate event handler EH. This may be done by processing the UUID markings of the events in correspondence to the respective event handlers EH. The dispatcher D may be called recursively by the event handlers EH (which in Fig. 1 should be represented with the double headed arrows form dispatcher D to event handler EH) for generating control commands to be used for execution on the MR scanner. The control commands may be provided on an output interface 106. The control commands may be used to control a second MR scanner MR2, which may have different properties than the first scanner MR1.

The event handlers EH may be dedicated to a specific task. Some event handlers are configured to process fundamental control data types f and other may be configured to process other data, e.g. sequence block control data types sb. It is to be noted, that only the event handlers EH for the fundamental control data types f are directly communicating with the output interface 106. The dispatcher D usually does not address the MR scanner MR, because the dispatcher D has no knowledge about the scanner. Please note, that the distinction between the different event handler types (one for fundamental control data types f and another one for sequence block control data types sb) is not explicitly represented in the figures for the sake of clarity.

In alternative embodiments it is also possible to provide the storages 103, 104 as a separate instance out of the system 100 and to connect them via network connection or interfaces. Further, it is possible to integrate the partitioning unit 102 and the mapping unit 105 into one common unit to interact with the dispatcher D.

As can be seen in Fig. 1, the event handlers EH may call libraries LIB to process the event e.

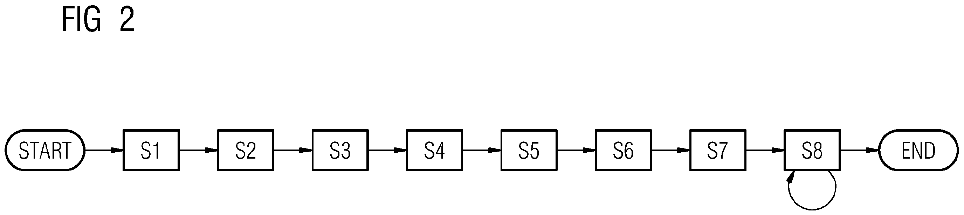

Fig. 2 shows a flow chart of a method according to a preferred embodiment of the invention. After START of the procedure, in step S1 a MR sequence is received. This may be executed via the input interface 101 or by reading from a local or external storage. In step S2 the received or read-in MR sequence is serialized and partitioned into time slices ts1, ts2, ...tsn.
In step S3 an extendable set of sequence block control data types are defined. A sequence block control data type represents a formalized and a self-contained description of a time slice ts of the MR sequence. In step S4 a set of fundamental control data types f (corresponding to low-level commands) is provided. The fundamental control data types f may be stored in a local storage 104. In step S5 a mapping is performed. Each time slice ts is mapped to an instance of a sequence block control data type sb for providing a stream of events e1, e2, e3,...ei, representing the received MR sequence. In step S7 a set of event handlers EH is provided, wherein each of the event handlers EH is adapted for processing at least one event e. In step S8 the dispatcher is accessed for reading each event e in the provided stream of events and passing each event e together with the dispatcher D itself to an appropriate event handler EH, so that the dispatcher D may be called recursively by the event handlers EH for generating control commands to be used for execution on the MR scanners MR1, MR2.

In a more particular preferred embodiment, it is possible to outsource the units 101, 102, 103, 104 and 105 of the system and to only include in the system 100 an input interface for receiving a stream of events e1, ...ei, which may e.g. be provided by an external mapping unit 105 and the dispatcher D and the event handlers EH. Since the event handlers EH may be extended easily by adding new event handlers, the system is highly scalable.

The proposed concept shows several advantages. The software architecture involved is minimal. The IRecursiveEventHandler is the only non-data software interface. The standardized control data format is not an interface and has no functionality, it only represents pure data collections that can easily be defined and understood. New IRecursiveEventHandler implementations and new control data types can be added to the system at any time and loaded during runtime without changing prior implementations (also by research customers or 3rd Party companies). Once a control data type is released the behavior of the MR scanner MR can be declared as stable for all future when it receives the released type. The implementation can change, but the scanner behavior remains. In particular this means that all implementations of IRecursiveEventHandler that only use the recursive feature, i.e. do not implement anything and just create new events and i.e. do not process fundamental control data types can be regarded as completely independent of a specific MR scanner architecture. The given concept defines the highest possible level of abstraction between the description of a pulse sequence and its actual execution on a hardware and software platform.

The interfaces of the system can be embodied as a hardware interface or as a software interface (e.g. PCI-Bus, USB or Fire-wire). In general, the system can comprise hardware elements and software elements, for example a microprocessor, a field programmable gate array (an acronym is "FPGA") or an application specific integrated circuit (an acronym is "ASIC"). The storages 103, 104 may be memory units and can be embodied as non-permanent main memory (e.g. random access memory - RAM) or as permanent mass storage (e.g. hard disk, USB stick, SD card, sol-id state disk).

The system 100 and the MR scanners MR may be connected via a network, which can be realized as a LAN (acronym for "local area network"), in particular a WiFi network, or any other local connection, e.g. via Bluetooth or USB (acronym for "universal serial bus"). The network can also be realized as a WAN (acronym for "wide area network"), in particular the network can be identical with the internet. The network can alternatively also be realized as a VPN (acronym for "virtual private network").

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality.

A single unit or device may fulfil the functions of several items recited in the claims. The mere fact that certain measures are recited in mutually different dependent claims does not indicate that a combination of these measures cannot be used to advantage.

The system for generating at least part of a pulse sequence to be executed on a magnetic resonance scanner in accordance with the method as described above can be implemented as program code means of a computer program and/or as dedicated hardware.

A computer program may be stored/distributed on a suitable medium, such as an optical storage medium or a solid-state medium, supplied together with or as part of other hardware, but may also be distributed in other forms, such as via the Internet or other wired or wireless telecommunication systems.

Any reference signs in the claims should not be construed as limiting the scope.

Wherever not already described explicitly, individual embodiments, or their individual aspects and features, described in relation to the drawings can be combined or exchanged with one another without limiting or widening the scope of the described invention, whenever such a combination or exchange is meaningful and in the sense of this invention. Advantageous which are described with respect to a particular embodiment of present invention or with respect to a particular figure are, wherever applicable, also advantages of other embodiments of the present invention.

## Claims

1. Computer implemented method for generating control commands for execution on an MR scanner (MR1, MR2), wherein the method comprises:
- Receiving a provided (S6) stream of events (e1, e2, ...ei) representing an MR sequence;
- Providing (S7) an event handler (EH) for each event (e) wherein each of the event handlers (EH) is adapted for processing at least one event (e);
- Accessing (S8) a dispatcher (D) for reading each event (e) in the provided stream of events and passing each event (e) together with the dispatcher (D) itself to an appropriate event handler (EH), so that the dispatcher (D) may be called recursively by the event handlers (EH) for generating control commands to be used for execution on the MR scanner (MR1, MR2).

2. Method according to claim 1, wherein providing (S6) the stream of events (e1, e2, ...ei) comprises:
- Receiving (S1) an MR sequence via an input interface (101);
- Partitioning (S2) the MR sequence in a sequence of time slices (ts1, ts2,...tsn), each time slice (ts) being a continuous uninterrupted period of time within the MR sequence;
- Defining (S3) an extendable set of sequence block control data types (sb1, sb2,...sbn), wherein a sequence block control data type (sb1, sb2,...sbn) represents a formalized and a self-contained description of a time slice (ts) of the MR sequence;
- Mapping (S5) each time slice (ts) to one instance of a sequence block control data type (sb) or to at least one instance of a fundamental control data type (f).

3. Method according to any of the preceding claims, each of the event handlers (EH) is able to create new events.

4. Method according to any of the preceding claims, wherein the event (e) in the stream of events is a package consisting of an UUID, a data size in bytes and the event data itself, wherein the UUID and the data size is accessible separately from the event data.

5. Method according to any of the preceding claims, wherein the assignment between event (e) and an appropriate event handler (EH) is realized by including a uniform and unique identifier, in particular a UUID in the event (e) and within the dispatcher (D) assigning this UUID to an event handler (EH).

6. Method according to any of the preceding claims, wherein the recursive calls to the dispatcher (D) can be used for applying a composite design pattern or a tree structure for generating the complete MR sequence.

7. Method according to any of the preceding claims, wherein the generated control commands are scanner-independent, wherein only the fundamental control data types have to be translated into scanner-specific control commands by the respective appropriate event handler (EH).

8. Method according to any of the preceding claims, wherein the dispatcher (D) and the event handler (EH) are both implementing the same interface for sequence block execution.

9. Method according to any of the preceding claims, wherein the definition of a set of sequence block control data types (sb) is based on a provided abstract model for MR sequences and wherein the model may be based on an extendable set of fundamental control data types (f).

10. Method according to any of the preceding claims, wherein a set of fundamental control data types (f) and a set of sequence block control data types (sb) may be extended by adding new control data types, being fundamental control data types (f) or sequence block control data types (sb), without affecting existing code.

11. Method according to any of the preceding claims, wherein the set of event handlers (EH) may be extended by adding new event handlers (EH) without affecting existing code.

12. Method according to any of the preceding claims, wherein the steps of mapping (S5), accessing (S8) the dispatcher (D) and calling the same recursively is implemented by an IRecursiveEventHandler interface.

13. Method according to any of the preceding claims, wherein the stream of events (e1, e2, ...ei) may be provided by an exchangeable software Plug-In into an MR control software executing the dispatcher (D).

14. Computing unit for generating control commands for execution on an MR scanner (Mr1, MR2), comprising:
- An input interface for receiving a provided stream of events (e1, e2, ...ei) representing the received MR sequence;
- An event handler (EH) for each event (e) wherein each of the event handlers (EH) is adapted for processing one or more specific events (e);
- A dispatcher (D) for reading each event (e) in the provided stream of events (e1, e2, ..ei) and passing each event(e) together with the dispatcher (D) itself to an appropriate event handler (EH), so that the dispatcher (D) may be called recursively by the event handlers (EH) for generating control commands to be used for execution on the MR scanner (MR1, MR2).

15. Computing unit according to the directly preceding claim, further comprising:
- An input interface (101) for receiving an MR sequence;
- A partitioning unit (102), which is adapted for partitioning the received MR sequence in a sequence of time slices (ts), each time slice (ts) being a continuous uninterrupted period of time within the MR sequence;
- A storage (103) for providing an extendable set of sequence block control data types (sb), wherein a sequence block control data type (sb) represents a formalized and self-contained description of a time slice (ts) of an MR sequence;
- A mapping unit (105) which is adapted for mapping each time slice (ts) to at least one instance of a sequence block control data type (sb) or to at least one instance of a fundamental control data type (f) for providing a stream of events (e1, e2, ...ei) representing the received MR sequence.

16. System (100) for generating control commands for execution on an MR scanner (Mr1, MR2), comprising:
- At least one MR scanner (MR) to be operated with control commands to be generated;
- A computing unit according to any of the directly preceding claims directed to the computing unit.

17. Computer program for generating an MR sequence or parts thereof, the computer program comprising program code means for causing a computing entity to carry out the method as defined in any of the method claims above, when the computer program is run on the computing entity.
